# EUROPÄISCHE PATENTANMELDUNG

(11) **EP 3 131 373 A1**
(43) Veröffentlichungstag der Anmeldung: **15.02.2017**
(21) Anmeldenummer: 16180455.4
(22) Anmeldetag: 20.07.2016
(51) Int. Cl.: H05K 1/14, H05K 3/36, H05K 1/02, H01R 12/71, H01R 12/73

(54) **SCHALTUNG AUF PLATINEN IN MEHREREN EBENEN MIT SCHNITTSTELLE FÜR STECKKARTE**

(30) Priorität: 23.07.2015 DE 102015111972
(71) Anmelder: ABB Schweiz AG, 5400 Baden (CH)
(72) Erfinder: Keul, Thomas, 63579 Freigericht (DE)
(74) Vertreter: Marks, Frank

(57) **Zusammenfassung**

Elektronische Schaltung, umfassend mindestens eine erste Platine (1), die in einer ersten Ebene (1 a) verläuft, sowie mindestens eine zweite Platine (2), die in einer zur ersten Ebene (1 a) parallelen, außerhalb dieser ersten Ebene (1 a) verlaufenden, zweiten Ebene (2a) verläuft, weiterhin umfassend mindestens eine erste Steckvorrichtung (11), die mit der ersten Platine (1) elektrisch kontaktiert ist, und eine zweite Steckvorrichtung (21), die mit der zweiten Platine (2) elektrisch kontaktiert ist und die auf der der ersten Platine (1) abgewandten Seite (2b) der zweiten Platine (2) angeordnet ist, wobei beide Steckvorrichtungen (11) und (21) gemeinsam zur Aufnahme einer zusammenhängenden Steckkarte (3) und zur elektrischen Kontaktierung dieser Steckkarte (3) mit beiden Platinen (1) und (2) ausgebildet sind, wobei die erste Steckvorrichtung (11) mindestens teilweise auf der der ersten Platine (1) abgewandten Seite (2c) der zweiten Ebene (2a) angeordnet ist.

## Beschreibung

Die Erfindung betrifft elektronische Schaltungen, die auf Platinen in mehreren Ebenen aufgeteilt sind und zusätzliche Steckkarten enthalten.

### Stand der Technik

Um Geräte der Industrieelektronik kompakter bauen zu können, werden mehrere in zwei Dimensionen mit Bauteilen bestückte Platinen in mehreren Ebenen übereinander angeordnet, so dass die auf allen Platinen vorhandenen Bauteile zusammen eine elektronische Schaltung bilden. Derartige Schaltungen beinhalten häufig Steckkarten, die mit einem Randstecker in Steckvorrichtungen auf den Platinen einsteckbar und auf diese Weise mit beiden Platinen elektrisch kontaktierbar sind. Baugruppen werden häufig dann auf Steckkarten realisiert, wenn vorgesehen ist, dass sie vom Benutzer nachträglich der Schaltung hinzugefügt oder während des Betriebes ausgetauscht werden. Steckkarten beinhalten daher insbesondere Erweiterungsmodule zum Nachrüsten zusätzlicher Funktionalitäten oder Kapazitäten, Speichermodule sowie Verschleißteile, deren Austausch im Laufe der Lebensdauer des Geräts wahrscheinlich ist.

Randstecker und die dazugehörigen Steckvorrichtungen, die zusammen eine sogenannte "card-edge"-Steckverbindung bilden, sind in vielen Baugrößen, Bauformen und Polzahlen jeweils genormt verfügbar. Soll ein und dieselbe Steckkarte mit zwei übereinander angeordneten Platinen gleichzeitig kontaktiert werden, so ist ein Höhenunterschied zwischen den Ebenen zu überbrücken, in denen diese beiden Platinen verlaufen. Mit den vorhandenen genormten Steckvorrichtungen lässt sich dies derzeit nur realisieren, indem der Teil der Steckkarte mit dem Randstecker, der in die Steckvorrichtung auf der tiefer gelegenen Platine eingreifen soll, um den Betrag des Höhenunterschieds über den Randstecker hinaus ragt, der in die Steckvorrichtung auf der höher gelegenen Platine eingreifen soll. Die Steckkarte braucht also eine abgestufte Kante, wenn ihre Randstecker in Steckvorrichtungen auf beiden Platinen gleichzeitig eingreifen sollen.

In der Industrieelektronik ist es häufig erforderlich, Steckkarten zum Schutz vor mechanischer Beschädigung in ein Modulgehäuse einzukapseln. Hierbei wirft es Probleme auf, wenn eine Steckkarte eine abgestufte Kante hat.

### Aufgabe und Lösung

Es ist daher die Aufgabe der Erfindung, eine elektronische Schaltung aus mehreren übereinander angeordneten Platinen bereitzustellen, in der beide Platinen mit ein und derselben Steckkarte verbindbar sind, ohne dass der Höhenunterschied zwischen beiden Platinen durch eine abgestufte Kante der Steckkarte überbrückt werden muss.

Diese Aufgabe wird erfindungsgemäß gelöst durch eine elektronische Schaltung gemäß Hauptanspruch. Weitere vorteilhafte Ausgestaltungen ergeben sich aus den daraus rückbezogenen Unteransprüchen.

### Gegenstand der Erfindung

Im Rahmen der Erfindung wurde eine elektronische Schaltung entwickelt. Diese Schaltung umfasst mindestens eine erste Platine, die in einer ersten Ebene verläuft, sowie mindestens eine zweite Platine, die in einer zur ersten Ebene parallelen, außerhalb dieser ersten Ebene verlaufenden, zweiten Ebene verläuft. Je nach Orientierung der Schaltung relativ zum Schwerefeld der Erde können die Platinen beziehungsweise die Ebenen beispielsweise übereinander, aber alternativ auch nebeneinander angeordnet sein.

Die Schaltung umfasst weiterhin mindestens eine erste Steckvorrichtung, die mit der ersten Platine, und damit auch mit den auf dieser ersten Platine enthaltenen Bauelementen, elektrisch kontaktiert ist. Sie umfasst auch mindestens eine zweite Steckvorrichtung, die mit mindestens der zweiten Platine, und damit auch mit den auf dieser zweiten Platine enthaltenen Bauelementen, elektrisch kontaktiert ist. Dabei ist diese zweite Steckvorrichtung auf der der ersten Platine abgewandten Seite der zweiten Platine angeordnet. Beide Steckvorrichtungen sind gemeinsam zur Aufnahme einer zusammenhängenden Steckkarte und zur elektrischen Kontaktierung dieser Steckkarte mit beiden Platinen ausgebildet.

Erfindungsgemäß ist die erste Steckvorrichtung mindestens teilweise auf der der ersten Platine abgewandten Seite der zweiten Ebene angeordnet.

Der bekannte Stand der Technik wird somit dahingehend abgeändert, dass der Abstand (Höhenunterschied) zwischen den beiden Platinen nicht mehr durch eine Anpassung der Steckkarte überbrückt wird, sondern durch eine Anpassung der ersten Steckvorrichtung. Die Steckkarte muss dann keine abgestufte Kante mehr haben. Weiterhin können auch Versionen der Schaltung mit verschiedenen Abständen zwischen den Platinen so ausgebildet sein, dass die Abmessungen der beiden Steckvorrichtungen und ihre Anordnung zueinander identisch sind. Es kann dann ein und dieselbe Steckkarte in beiden Versionen der Schaltung zum Einsatz kommen. Dementsprechend werden Mehrkosten bei der Fertigung eingespart, die bei der Herstellung mehrerer funktionsgleicher Steckkarten mit unterschiedlichen mechanischen Abmessungen anfallen würden.

Die beiden Steckvorrichtungen können insbesondere jeweils als das weibliche Teil der card-edge-Steckverbindung ausgebildet sein. Sie können beispielsweise jeweils Kontaktfedern aufweisen, die den elektrischen Kontakt zu Kontaktflächen auf einem Randstecker der Steckkarte herstellen und gleichzeitig die Steckkarte durch Haftreibung in Position halten. Daneben können die Steckvorrichtungen beispielsweise weitere Vorrichtungen zur mechanischen Arretierung einer eingeführten Steckkarte sowie Codierungen, die das Einsetzen einer ungeeigneten oder verpolten Steckkarte verhindern, enthalten.

Vorteilhaft umfasst die Schaltung eine Steckkarte, die über die beiden Steckvorrichtungen mit beiden Platinen kontaktiert ist. Der Teil der Schaltung, der die beiden Platinen mit den zugehörigen Steckvorrichtungen umfasst, einerseits und die passenden Steckkarten andererseits sind jedoch Produkte, die auch unabhängig voneinander hergestellt und verkauft werden können. Zugleich müssen die Steckkarten für die Nutzung im Zusammenhang der Erfindung nicht zwangsläufig neu angefertigt werden. Stattdessen erweitert die Erfindung auch für bereits existierende Steckkarten vorteilhaft den Kreis der Schaltungen, in denen diese genutzt werden können.

In einer besonders vorteilhaften Ausgestaltung der Erfindung ist die erste Steckvorrichtung auf der ersten Platine angeordnet und durch die zweite Platine hindurch geführt. Sie kann dann insbesondere an die zweite Steckvorrichtung angrenzen und/oder mit dieser bündig abschließen. Beide Steckvorrichtungen können dann quasi zu einer einzigen Steckvorrichtung verschmelzen, in die ein zusammenhängender Randstecker der Steckkarte mit einer geraden Kante einführbar ist. Eine erste Teilmenge der Anschlüsse des Randsteckers ist dann über die erste Steckvorrichtung mit der ersten Platine kontaktiert, während eine zweite Teilmenge der Anschlüsse am Randstecker über die zweite Steckvorrichtung mit der zweiten Platine kontaktiert ist.

Eine Steckkarte, die in diesem Ausführungsbeispiel zum Einsatz kommt, kann wahlweise auch in einer Schaltung zum Einsatz kommen, die die gleiche Funktionalität auf einer einzigen Platine realisiert und nur eine einzige Steckvorrichtung aufweist, die der bei der Aufteilung auf zwei Platinen verwendeten Kombination aus beiden Steckvorrichtungen entspricht. Umgekehrt kann eine existierende Steckkarte, die bislang in einer Schaltung mit nur einer einzigen Platine genutzt wurde, unverändert weiter genutzt werden, wenn diese Schaltung später auf zwei Platinen aufgeteilt wird. Die Erfindung abstrahiert auf diese Weise die dem Randstecker der Steckkarte dargebotene Schnittstelle von der Realisierung und geometrischen Aufteilung der Schaltung, die sich hinter dieser Schnittstelle verbirgt.

Es ist somit generell vorteilhaft, wenn jede der Steckvorrichtungen zur Aufnahme mindestens eines Randsteckers der Steckkarte ausgebildet ist. Es ist insbesondere generell vorteilhaft, wenn beide Steckvorrichtungen gemeinsam zur Aufnahme ein und desselben Randsteckers der Steckkarte ausgebildet sind. Es generell besonders bevorzugt, wenn beide Steckvorrichtungen einen gemeinsamen Anschlag für eine gerade Kante ein und desselben Randsteckers der Steckkarte aufweisen.

Um die vorstehend beschriebene erste Ausführungsform der Erfindung zu realisieren, ist gegenüber dem Stand der Technik nur die erste Steckvorrichtung abzuändern. Es kann der Fall eintreten, dass für einen vorgegebenen Abstand zwischen beiden Platinen keine passende erste Steckvorrichtung in Normgröße zur Verfügung steht. Daher ist in einer zweiten vorteilhaften Ausführungsform der Erfindung die erste Steckvorrichtung auf der zweiten Platinen angeordnet und über eine Leitung mit der ersten Platine elektrisch kontaktiert.

Es kann dann die erste Steckvorrichtung entsprechend der bisher verwendeten Normgröße ohne Änderung weiter verwendet werden. Insbesondere können sich, völlig analog zur ersten Ausführungsform, beide Steckvorrichtungen gemeinsam gegenüber dem Randstecker der Steckkarte als eine einzige Steckvorrichtung präsentieren. Somit werden die gleichen Vorteile erreicht wie bei der ersten Ausführungsform. Statt eine normabweichende erste Steckverbindung einzusetzen, wird die Normabweichung jedoch in die Leitung verlagert, die die erste Steckvorrichtung mit der ersten Platine verbindet. Dies kann wesentlich einfacher sein als die Fertigung einer normabweichenden ersten Steckvorrichtung. So sind beispielsweise in vielen Anwendungen der Industrieelektronik beide Platinen an ein gemeinsames Bussystem angeschlossen, das verwendet werden kann, um den Kontakt zwischen der ersten Steckvorrichtung und der ersten Platine herzustellen.

Die beiden Steckvorrichtungen müssen in dieser Ausführungsform auch keine separaten Komponenten sein. Sie können auch von vornherein zu einer einzigen Steckvorrichtung zusammengefasst sein, die lediglich logisch in zwei Steckvorrichtungen aufgeteilt ist. Eine erste Teilmenge von Kontakten, die elektrisch mit der ersten Platine verbunden sind, gehört dann logisch zur ersten Steckvorrichtung. Eine zweite Teilmenge von Kontakten, die elektrisch mit der zweiten Platine verbunden sind, gehört logisch zur zweiten Steckvorrichtung. Eine solche Aufteilung ermöglicht es beispielsweise, die Kontakte und ihre Gegenstücke an der Steckkarte nach ihrer Funktion zu gruppieren statt nach der Platine, mit der sie verbunden sind.

So kann der Randstecker der Steckkarte beispielsweise sowohl für die Verbindung zur ersten Platine als auch für die Verbindung zur zweiten Platine jeweils einen ersten Satz Kontakte aufweisen, die nur einen relativ geringen Strom tragen müssen, beispielsweise für die Übertragung von Steuersignalen. Daneben kann jeweils auch ein zweiter Satz Kontakte vorgesehen sein, die einen deutlich höheren Strom tragen müssen, beispielsweise für die Übertragung von Leistung an einen motorischen Aktor. Sowohl die Fertigung der Steckkarte als auch die Fertigung der Platinen wird vereinfacht, wenn in der Kontaktbelegung an der card-edge-Steckverbindung diejenigen Kontakte, die einen relativ geringen Strom tragen müssen, in einer ersten zusammenhängenden Gruppe und diejenigen Kontakte, die einen höheren Strom tragen müssen, in einer zweiten zusammenhängenden Gruppe zusammengefasst sind.

Die wesentlichen Vorteile der Erfindung lassen sich in einer dritten Ausführungsform der Erfindung realisieren, ohne dass an der zweiten Platine eine Veränderung vorgenommen werden muss. In dieser dritten Ausführungsform ist die erste Steckvorrichtung auf der ersten Platine angeordnet und außerhalb der zweiten Platine durch die zweite Ebene hindurch geführt. Auch bei dieser Ausführungsform können die beiden Steckvorrichtungen so zusammenwirken, dass sie zu einer einzigen Steckvorrichtung verschmelzen und ein und denselben Randstecker der Steckkarte fassen. Der einzige Unterschied ist, dass dann zwischen der ersten Steckvorrichtung und der zweiten Steckvorrichtung einen Bereich geben kann, in dem keine Kontaktfedern den Randstecker umgreifen.

Die Ausführungsformen sind auch miteinander kombinierbar. So kann beispielsweise ein erster als Randstecker ausgebildeter Bereich der Steckkarte in eine erste Steckvorrichtung und in eine zweite Steckvorrichtung eingreifen, die im Bereich der zweiten Platine unmittelbar aneinander angrenzen. Dieser als Randstecker ausgebildete Bereich der Steckkarte ist dann mit der zweiten Platine sowie mit einem ersten Bereich auf der ersten Platine kontaktiert. Daneben kann es noch einen zweiten als Randstecker ausgebildeten Bereich der Steckkarte geben, der außerhalb der zweiten Platine und in einiger Entfernung zu dieser zweiten Platine in eine auf der ersten Platine angeordnete, durch die zweite Ebene hindurch geführte, weitere Steckvorrichtung eingreift. Auf diese Weise lässt sich die Steckkarte parallel auch mit einem weiteren Bereich auf der ersten Platine kontaktieren. So können beispielsweise erforderliche Verdrahtungen vereinfacht und verkürzt werden.

In einer besonders vorteilhaften Ausgestaltung der Erfindung ist die Steckkarte einschließlich ihrer Randstecker in einem Modulgehäuse angeordnet, welches zu der Seite, mit der die Steckkarte in die Steckvorrichtungen einführbar ist, geöffnet oder zu öffnen ist. Ein solches Modulgehäuse schützt die Steckkarte vor mechanischen Beschädigungen. Beispielsweise können dann mehrere Steckkarten im Rahmen der Vorratshaltung ohne weitere Umverpackung gestapelt werden. Das Modulgehäuse kann elastischer ausgebildet sein als die Steckkarte selbst und bei einem Sturz der Steckkarte auf den Boden den größten Teil der Aufprallenergie abfedern. Die Verwendung eines Modulgehäuses ist durch den Wegfall der Notwendigkeit, die Steckkarte mit einer abgestuften Kante zu versehen, wesentlich vereinfacht.

In einer weiteren besonders vorteilhaften Ausgestaltung der Erfindung sind beide Platinen in einem gemeinsamen Gehäuse angeordnet, welches Mittel zur Führung der Steckkarte, und/oder ihres Modulgehäuses, zur Herstellung des elektrischen Kontakts zwischen der Steckkarte und den beiden Steckverbindungen aufweist. Eine Führung des Modulgehäuses hat den Vorteil, dass dieses unempfindlicher ist als die Steckkarte selbst. Wird beispielsweise versucht, eine Steckkarte verpolt oder an einem ungeeigneten Platz einzusetzen, so können entsprechende Codierungen am Modulgehäuse größeren Kräften widerstehen.

Da ein Abstand zwischen den beiden Platinen entsprechend der Erfindung einfacher zu überbrücken ist, lassen sich beispielsweise geforderte Isolationsabstände zwischen den beiden Platinen einfacher realisieren. In diesem Zusammenhang kann die Aufteilung der elektronischen Schaltung auf zwei Platinen nicht nur genutzt werden, um den Platz im Gehäuse besser auszunutzen, sondern auch die Betriebssicherheit erhöhen. Dazu kann in einer weiteren besonders vorteilhaften Ausgestaltung der Erfindung der auf der ersten Platine angeordnete Teil der Schaltung mindestens in einem Teilbereich eine betragsmäßig höhere Nennspannung aufweisen als der auf der zweiten Platine angeordnete Teil der Schaltung. Beispielsweise kann die erste Platine diejenigen Komponenten beinhalten, die Netzspannung oder andere gefährliche Spannungen führen, während auf der zweiten Platine nur Komponenten angeordnet sind, die Kleinspannung führen. Dies ist dann für den Monteur, der Arbeiten an der Schaltung durchführt, unmittelbar einsichtig. Insbesondere kann die zweite Platine den Teilbereich, der die betragsmäßig höhere Nennspannung aufweist, beührsicher abdecken. Unter "berührsicher" wird in diesem Zusammenhang verstanden, dass es mit dem genormten Prüffinger nicht möglich ist, in Kontakt mit der betragsmäßig höheren Nennspannung zu kommen. Solange die zweite Platine in Position ist, können Arbeiten an der Schaltung dann ohne besondere Vorsichtsmaßnahmen für das Arbeiten unter Spannung durchgeführt werden.

Nachfolgend wird der Gegenstand der Erfindung anhand von Figuren erläutert, ohne dass der Gegenstand der Erfindung hierdurch beschränkt wird. Es ist gezeigt:
- Figur 1: Ausführungsbeispiel der Erfindung gemäß der ersten Ausführungsform.
- Figur 2: Ausführungsbeispiel der Erfindung gemäß der zweiten Ausführungsform.
- Figur 3: Ausführungsbeispiel der Erfindung gemäß der dritten Ausführungsform.
- Figur 4: Einbau der Schaltung in ein Gehäuse.

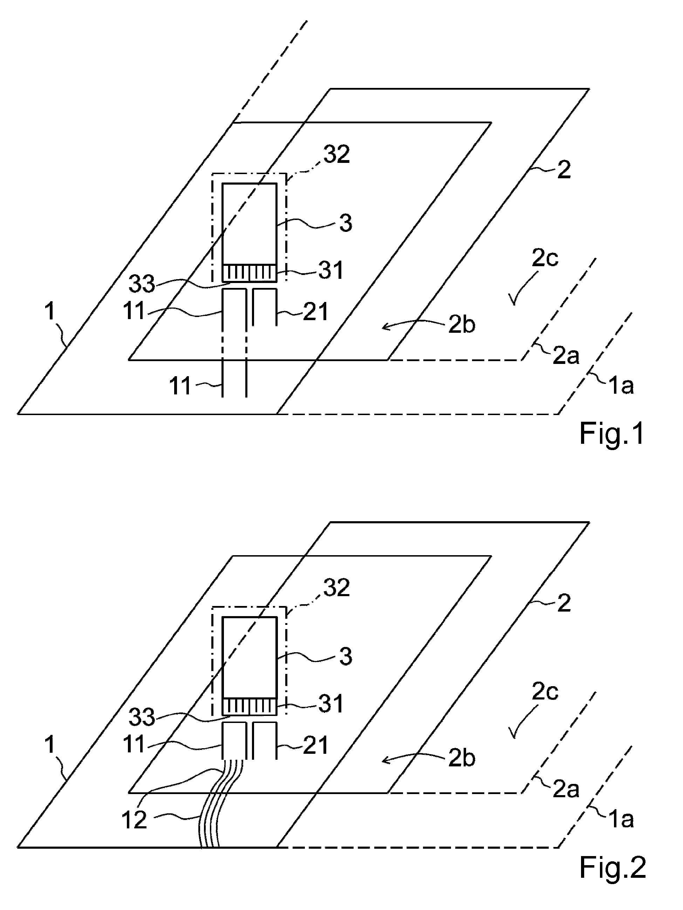

Figur 1 zeigt ein Ausführungsbeispiel gemäß der ersten Ausführungsform der Erfindung in schematischer, perspektivischer Darstellung. Die erste Platine **1** verläuft in einer ersten Ebene **1a,** deren weiterer Verlauf durch die gestrichelten Linien angedeutet ist. Die zweite Platine **2** verläuft in einer zweiten Ebene **2a**, deren Verlauf ebenfalls durch gestrichelte Linien angedeutet ist. Auf der zweiten Platine **2** ist eine zweite Steckvorrichtung **21** angeordnet, die den Kontakt zwischen der Steckkarte **3** und der zweiten Platine **2** herstellt. Diese Steckvorrichtung **21** befindet sich auf der der ersten Platine **1** abgewandten Seite **2b** der zweiten Platine. Sie befindet sich damit auch auf der der ersten Platine **1** abgewandten Seite **2c** der zweiten Ebene **2a.**

Die erste Steckvorrichtung **11** ist nun auf der ersten Platine **1** angeordnet und durch die zweite Platine **2** hindurch geführt. Ein Teilbereich dieser ersten Steckvorrichtung **11** ragt damit über die der ersten Platine **1** abgewandte Seite **2b** der Platine **2** hinaus und grenzt unmittelbar an die zweite Steckvorrichtung **21** an. Die erste Steckvorrichtung **11** stellt so den Kontakt zwischen der Steckkarte **3** und der ersten Platine **1** her. Indem ein Teilbereich der ersten Steckvorrichtung **11** über die zweite Platine **2** hinausragt, ist dieser Teilbereich auch automatisch auf der der ersten Platine **1** abgewandten Seite **2c** der zweiten Ebene **2a** angeordnet.

Die Steckkarte **3** hat einen Randstecker **31**, der eine gerade Unterkante **33** aufweist und mit dieser Unterkante **33** gleichzeitig in beide Steckvorrichtungen **11** und **21** einführbar ist. Beide Steckvorrichtungen **11** und **21** sind somit gemeinsam zur Aufnahme dieses einen Randsteckers **31** ausgebildet. Sie haben außerdem einen gemeinsamen Anschlag für die gerade Unterkante **33** dieses Randsteckers **31.** Beide Steckvorrichtungen **11** und **21** präsentieren sich gegenüber dem Randstecker **31** somit als eine einzige Steckvorrichtung.

Die Steckkarte **3** ist einschließlich des Randsteckers **31** in einem Modulgehäuse **32** angeordnet. Dieses Modulgehäuse **32** ist zu der Seite, mit der der Randstecker 31 der Steckkarte **3** in die Steckvorrichtungen **11** und **21** einführbar ist, geöffnet.

Das in Figur 2 gezeigte Ausführungsbeispiel gemäß der zweiten Ausführungsform der Erfindung ist gegenüber dem in Figur 1 gezeigten Ausführungsbeispiel dahingehend abgewandelt, dass nun auch die erste Steckvorrichtung **11** auf der zweiten Platine **2** montiert ist. Dementsprechend hat diese erste Steckvorrichtung **11** Normgröße. Der Abstand zwischen den Platinen **1** und **2** wird durch die Leitung **12** überbrückt, die die erste Steckvorrichtung **11** mit der ersten Platine **1** verbindet. In Figur 2 geschieht dies über eine erste Teilstrecke in der Ebene der zweiten Platine **2** bis zu deren vorderen Rand und über eine anschließende zweite Teilstrecke nach unten zur ersten Platine **1.**

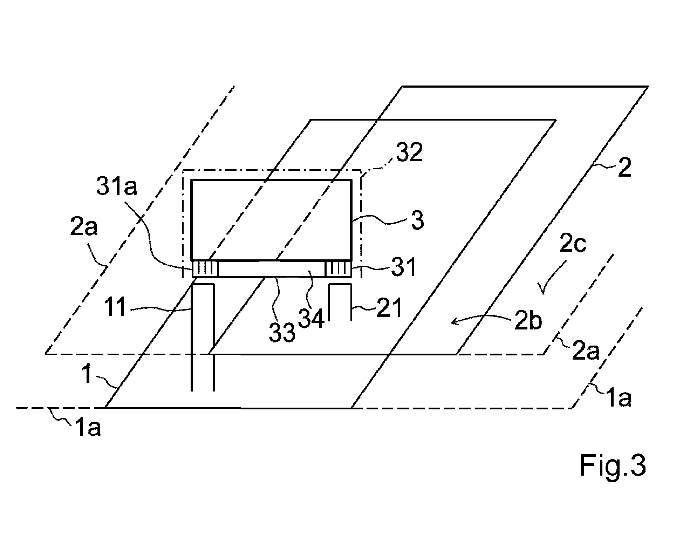

Figur 3 zeigt ein weiteres Ausführungsbeispiel gemäß der dritten Ausführungsform der Erfindung. Dieses Ausführungsbeispiel unterscheidet sich von dem in Figur 1 gezeigten Ausführungsbeispiel dahingehend, dass die erste Steckvorrichtung **11** nicht mehr durch die zweite Platine **2** geführt ist, sondern außerhalb des Bereichs angeordnet ist, in dem die zweite Platine **2** sich über der ersten Platine 1 erstreckt. Die Steckkarte **3** hat nun zwei Randstecker **31** und **31a,** die auf gleicher Höhe in die Steckvorrichtungen **21** beziehungsweise **11** eingreifen. Beide Randstecker **31 und 31a** enden in einer gemeinsamen geraden Unterkante **33.** Der Bereich **34** zwischen den Randsteckern **31** und **31a** kann optional aus der geraden Unterkante **33** der Steckkarte **3** ausgespart werden. Auch dann sind die beiden Randstecker **31** und **31a** noch gemäß der Erfindung besser durch das Modulgehäuse **32** schützbar als nach dem bisherigen Stand der Technik, denn dies ergibt sich schon daraus, dass beide Randstecker **31** und **31a** in der gemeinsamen geraden Unterkante **33** enden und der eine Randstecker nicht mehr über den anderen Randstecker hinausragen muss.

Dieses Ausführungsbeispiel hat gegenüber dem in Figur 1 gezeigten Ausführungsbeispiel den Vorteil, dass an der zweiten Platine **2** nichts geändert werden muss. Bei der Nachrüstung einer bestehenden Schaltung ist nur die bisherige erste Steckvorrichtung auf der ersten Platine **1** gegen die neue erste Steckvorrichtung **11** auszutauschen.

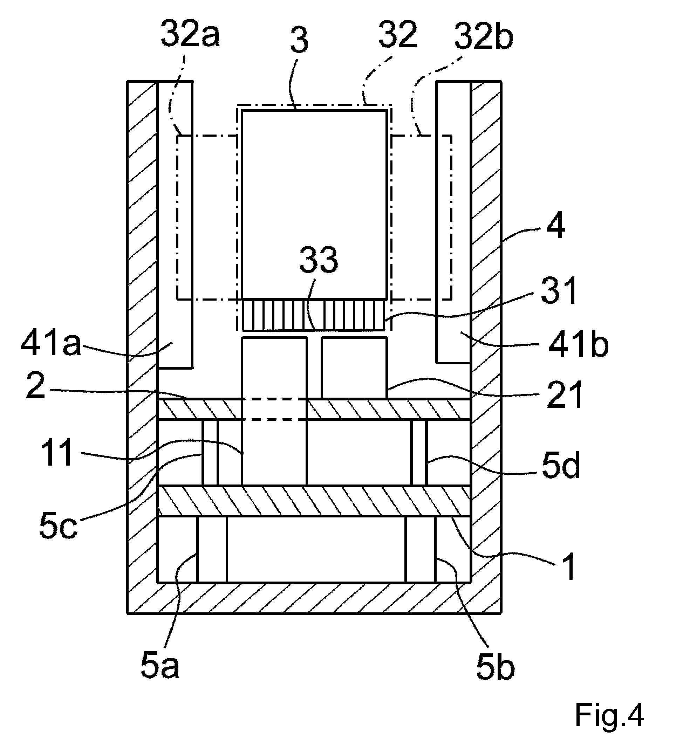

Figur 4 verdeutlich den Einbau der erfindungsgemäßen Schaltung in ein Gehäuse **4.** Innerhalb dieses Gehäuses **4** ruht die erste Platine **1** auf Abstandhaltern **5a** und **5b**, die auf dem Boden des Gehäuses **4** stehen. Die zweite Platine **2** ruht über Abstandhalter **5c** und **5d** auf der ersten Platine **1.** Die zweite Steckvorrichtung **21** ist auf der zweiten Platine **2** montiert. Die erste Steckvorrichtung **11** ist, entsprechend dem in Figur 1 gezeigten Ausführungsbeispiel, auf der ersten Platine **1** montiert und durch die zweite Platine hindurch geführt, so dass ihr oberer Bereich unmittelbar an die zweite Steckvorrichtung **21** angrenzt und beide Steckvorrichtungen **11** und **21** gemeinsam zur Aufnahme des Randsteckers **31** der Steckkarte **3** ausgebildet sind. Der Randstecker **31** endet in einer geraden Unterkante **33.**

Das Gehäuse 4 weist Führungsschienen **41 a** und **41 b** auf. Das Modulgehäuse **32**, in dem die Steckkarte **3** einschließlich ihres Randsteckers **31** angeordnet ist, weist zwei Vorsprünge **32a** und **32b** auf, die in den Führungsschienen **41a** und **41b** des Gehäuses **4** geführt sind. Die Vorsprünge **32a** und **32b** einerseits, und die Führungsschienen **41a** und **41 b** andererseits, weisen Codierungselemente auf, die sicherstellen, dass an dieser Stelle des Gehäuses **4** nur eine Steckkarte **3** des richtigen Typs mit der richtigen Polarität eingesetzt werden kann. Sodann stellen die Führungsschienen sicher, dass sich der Randstecker **31** beim Einführen in die Steckvorrichtungen **11** und **21** nicht verkantet. Bei einem solchen Verkanten könnte der Randstecker **31** möglicherweise brechen.

In den gezeigten Ausführungsbeispielen ist der Randstecker **31** stets das männliche Teil der card-edge-Steckverbindung und die Steckvorrichtungen **11** und **21** bilden den weiblichen Teil der card-edge-Steckverbindung. Die Erfindung funktioniert jedoch völlig analog, wenn die Steckvorrichtungen **11** und **21** als das männliche Teil und die Randstecker **31** und **31a** als das weibliche Teil der card-edge-Steckverbindung ausgebildet sind.

Ein wesentlicher Vorteil ist auch, dass beim Steckverbinder **11** nur die Verbindung der Federelemente (Weibchen) zu den Lötstiften verlängert wird um den Ebenen-Ausgleich zwischen den Ebenen **1a** und **2a** zu erreichen. Dadurch wird der grundlegende Aufbau eines Randsteckverbinders nicht verändert, sodass keine zusätzlichen Bauteile erforderlich sind bzw. die Herstellung des Steckverbinders **11** mit bekannten Fertigungsverfahren effektiv erfolgen kann. Es wird lediglich etwas mehr Material benötigt.

Darüber hinaus erlauben weitere Ausführungsformen zueinander geneigte Ebenen der Platinen **1** und **2** sowie gewinkelte Steckverbinder **11.**

### Bezugszeichenliste

- 1: erste Platine
- 1a: Ebene, in der erste Platine 1a verläuft
- 2: zweite Platine
- 2a: Ebene, in der zweite Platine 2 verläuft
- 2b: der ersten Platine 1 abgewandte Seite der zweiten Platine 2
- 2c: der ersten Platine 1 abgewandte Seite der zweiten Ebene 2a
- 11: erste Steckvorrichtung, mit der ersten Platine 1 verbunden
- 12: Leitung von der ersten Steckvorrichtung 1 zur ersten Platine 1
- 21: zweite Steckvorrichtung, mit der zweiten Platine 2 verbunden
- 3: Steckkarte
- 31, 31 a: Randstecker der Steckkarte 3
- 32: Modulgehäuse der Steckkarte 3
- 32a, 32b: Vorsprünge des Modulgehäuses 32
- 33: gerade Kante (Unterkante) des Randsteckers 31, 31 a
- 34: Bereich zwischen den Randsteckern 31 und 31 a
- 4: Gehäuse
- 41 a, 41 b: Führungsschienen des Gehäuses 4
- 5a-5d: Abstandhalter

## Patentansprüche

1. Elektronische Schaltung, umfassend mindestens eine erste Platine (1), die in einer ersten Ebene (1a) verläuft, sowie mindestens eine zweite Platine (2), die in einer zur ersten Ebene (1 a) parallelen, außerhalb dieser ersten Ebene (1 a) verlaufenden, zweiten Ebene (2a) verläuft, weiterhin umfassend mindestens eine erste Steckvorrichtung (11), die mit der ersten Platine (1) elektrisch kontaktiert ist, und eine zweite Steckvorrichtung (21), die mit der zweiten Platine (2) elektrisch kontaktiert ist und die auf der der ersten Platine (1) abgewandten Seite (2b) der zweiten Platine (2) angeordnet ist, wobei beide Steckvorrichtungen (11) und (21) gemeinsam zur Aufnahme einer zusammenhängenden Steckkarte (3) und zur elektrischen Kontaktierung dieser Steckkarte (3) mit beiden Platinen (1) und (2) ausgebildet sind,
**dadurch gekennzeichnet,**
**dass** die erste Steckvorrichtung (11) mindestens teilweise auf der der ersten Platine (1) abgewandten Seite (2c) der mindestens zweiten Ebene (2a) angeordnet ist.

2. Elektronische Schaltung nach Anspruch 1,
**dadurch gekennzeichnet,**
**dass** die erste Steckvorrichtung (11) auf der ersten Platine (1) angeordnet und durch die zweite Platine (2) hindurch geführt ist.

3. Elektronische Schaltung nach einem der Ansprüche 1 bis 2,
**dadurch gekennzeichnet,**
**dass** die erste Steckvorrichtung (11) auf der zweiten Platine (2) angeordnet und über eine Leitung (12) mit der ersten Platine (1) elektrisch kontaktiert ist.

4. Elektronische Schaltung nach einem der Ansprüche 1 bis 3,
**dadurch gekennzeichnet,**
**dass** die erste Steckvorrichtung (11) auf der ersten Platine (1) angeordnet und außerhalb der zweiten Platine (2) durch die zweite Ebene (2a) hindurch geführt ist.

5. Elektronische Schaltung nach einem der Ansprüche 1 bis 4,
**dadurch gekennzeichnet,**
**dass** jede der Steckvorrichtungen (11) und (21) zur Aufnahme mindestens eines Randsteckers (31, 31 a) der Steckkarte (3) ausgebildet ist.

6. Elektronische Schaltung nach Anspruch 5,
**dadurch gekennzeichnet,**
**dass** beide Steckvorrichtungen (11) und (21) gemeinsam zur Aufnahme ein und desselben Randsteckers (31, 31 a) der Steckkarte (3) ausgebildet sind.

7. Elektronische Schaltung nach Anspruch 6,
**dadurch gekennzeichnet,**
**dass** beide Steckvorrichtungen (11) und (21) einen gemeinsamen Anschlag für eine gerade Kante (33) ein und desselben Randsteckers (31, 31 a) der Steckkarte (3) aufweisen.

8. Elektronische Schaltung nach einem der Ansprüche 1 bis 7,
**dadurch gekennzeichnet,**
**dass** die Steckkarte (3) einschließlich ihrer Randstecker (31, 31 a) in einem Modulgehäuse (32) angeordnet ist, welches zu der Seite, mit der die Steckkarte (3) in die Steckvorrichtungen (11) und (21) einführbar ist, geöffnet oder zu öffnen ist.

9. Elektronische Schaltung nach einem der Ansprüche 1 bis 8,
**dadurch gekennzeichnet,**
**dass** beide Platinen (1) und (2) in einem gemeinsamen Gehäuse (4) angeordnet sind, welches Mittel (41) zur Führung der Steckkarte (3), und/oder ihres Modulgehäuses (32), zur Herstellung des elektrischen Kontakts zwischen der Steckkarte (3) und den beiden Steckvorrichtungen (11) und (21) aufweist.

10. Elektronische Schaltung nach einem der Ansprüche 1 bis 9,
**dadurch gekennzeichnet,**
**dass** der auf der ersten Platine (1) angeordnete Teil der Schaltung mindestens in einem Teilbereich (12) eine betragsmäßig höhere Nennspannung aufweist als der auf der zweiten Platine (2) angeordnete Teil der Schaltung.

11. Elektronische Schaltung nach Anspruch 10,
**dadurch gekennzeichnet,**
**dass** die zweite Platine (2) den Teilbereich (12) berührsicher abdeckt.
